# EUROPEAN PATENT APPLICATION

(11) **EP 1 699 269 A1**
(43) Date of publication of application: **06.09.2006**
(21) Application number: 04808025.3
(22) Date of filing: 21.12.2004
(51) Int. Cl.: H05B 33/14, H05B 33/22

(54) **ORGANIC SEMICONDUCTOR LIGHT-EMITTING DEVICE**

(30) Priority: 26.12.2003 JP 2003433425
(71) Applicant: Pioneer Corporation, Tokyo 153-8654 (JP)
(72) Inventor: NAKAMURA, Kenji, Corporate Res. & Develp. Labort., Tsurugashima-shi, Saitama 350-2288 (JP); KUDO, Kazuhiro, Chiba-shi, Chiba 260-0806 (JP)
(74) Representative: Manitz, Finsterwald & Partner GbR
(86) International application number: PCT/JP2004/019674
(87) International publication number: WO 2005/064996

(57) **Abstract**

A light-emitting device having an organic semiconductor layer and a control electrode electrically coupled to the semiconductor layer, the organic semiconductor layer being provided between a first electrode and an emission layer and having an absorption band within an emission wavelength band of the emission layer.

## Description

### TECHNICAL FIELD

The present invention relates to an organic semiconductor light-emitting device, and more particularly, to a device such as an organic semiconductor light-emitting device having a switching capability.

### BACKGROUND ART

An organic electroluminescence device (referred to below as an organic EL device) of a self-emission type, having various advantages such as very high response speed and high luminance, has been developed. An organic EL device having a switching capability has also been proposed (for example, see Japanese Patent Publication Kokai No.2003-187983).

A Light-emitting display in which such organic EL devices are disposed in a matrix has been drawn attention as a wide viewing angle, thin type, low power consumption display apparatus, and has been widely developed.

To perform an active-drive operation of a conventional EL device, at least two or more switching elements such as thin film transistors (TFTs) and at least one or more capacitors are required for a single EL device, since the EL device is a passive device. Accordingly, there is a problem with an active-matrix drive display using the organic EL devices that the aperture ratio for the pixels is decreased, since switching elements such as TFTs and capacitors must be formed in a single pixel. This leads to increase of power consumption to obtain enough luminance. Another problem is that the emission life time of the organic EL device becomes shorter.

An organic EL device having higher luminance and visibility is also desired to achieve a high performance, low cost display apparatus.

### DISCLOSURE OF THE INVENTION

The present invention addresses the abovementioned problems, with an object of providing a device such as an organic semiconductor light-emitting device having a switching capability, a high luminance, and a high performance. Problems solved by the invention include the ones described above as examples.

An organic semiconductor light-emitting device according to the present invention has a first electrode, a second electrode, and an emission layer provided between the first and second electrodes, which comprises an organic semiconductor layer and a control electrode electrically coupled thereto, the organic semiconductor layer being provided between the first electrode and the emission layer and having an absorption band within an emission wavelength band of the emission layer.

### BRIEF DESCRIPTION OF THE DRAWINGS

Fig. 1 is a cross-sectional view schematically showing the configuration of an organic EL device of an optical thyristor type according to a first embodiment of the present invention;
Fig. 2 is a plan view showing an exemplary shape of a gate electrode in the plane perpendicular to a layer stack direction;
Fig. 3 is a cross-sectional view of an organic EL device showing another exemplary shape of a gate electrode, in which the gate electrode is formed so as to be buried in the organic semiconductor layer;
Fig. 4 shows an EL emission spectrum (dashed line) of the emission layer 25 and an absorption spectrum (solid line) of the first and second organic semiconductor layers;
Fig. 5 is a cross-sectional view showing the configuration of a photosensitive SIT, which is used for verifiying the basic operation of the organic EL device in Fig. 1;
Fig. 6 shows characteristics of the drain-source current (I_{DS}) versus the drain-source voltage (V_{DS}) for the photosensitive SIT shown in Fig. 5, obtained without external illumination;
Fig. 7 shows characteristics of the drain-source current (I_{DS}) versus the drain-source voltage (V_{DS}) for the photosensitive SIT shown in Fig. 5, obtained with external illumination;
Fig. 8 shows an EL emission spectrum (dashed line) of the emission layer and an absorption spectrum (solid line) of the first and second organic semiconductor layers of an organic EL device according to a second embodiment of the present invention;
Fig. 9 is a cross-sectional view schematically showing the configuration of an organic EL device of an optical thyristor type according to a third embodiment of the present invention; and
Fig. 10 is a cross-sectional view schematically showing a structure of an organic EL device of an optical thyristor type according to a fourth embodiment of the present invention.

### EMBODIMENTS FOR CARRYING OUT THE INVENTION

Embodiments of the present invention will now be described below in detail with reference to the attached drawings, in which like elements are indicated by like reference characters.

### [First Embodiment]

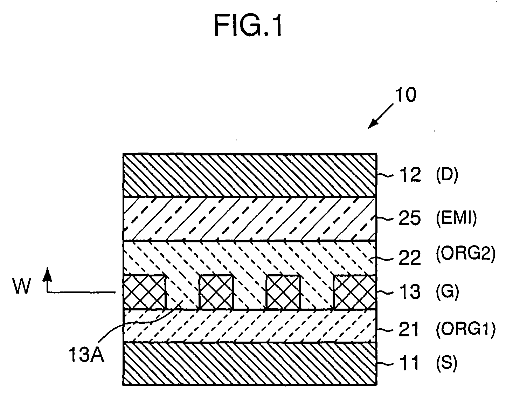

Fig. 1 is a cross-sectional view schematically showing the configuration of an organic EL device 10 of an optical thyristor type according to a first embodiment of the present invention.

The organic EL device 10 comprises: a source electrode (S) 11 as a first electrode; a drain electrode (D) 12 as a second electrode; and a gate electrode (G) 13 between the source electrode (S) 11 and the drain electrode (D) 12 as a control electrode. The organic EL device 10 further comprises: a first organic semiconductor layer (ORG1) 21 between the source electrode (S) 11 and the gate electrode (G) 13; and a second organic semiconductor layer (ORG2) 22 and an emission layer (EMI) 25 both between the gate electrode (G) 13 and the drain electrode (D) 12.

The source electrode (S) 11, the drain electrode (D) 12, and the gate electrode (G) 13 can be formed of an alkali metal such as gold, platinum, palladium, silver, lead, tin, aluminum, calcium, indium, chromium, and lithium, an alkaline earth metal such as magnesium, or an alloy thereof. An alkali metal compound, an alkaline earth metal compound, indium tin oxide (ITO), tin oxide, indium zinc oxide, zinc oxide, or an alloy thereof may also be used to form these electrodes. Alternatively, materials including selenium, copper iodide, and nickel may be used. Further, a conductive polymer such as poly(3-methylthiophene), polyphenylene sulfide, or polyaniline may also be used. These materials may be used as a single film or a multi-layer film such as, for example, a polyaniline layer formed on an ITO layer.

For the first organic semiconductor (ORG1) 21 and the second organic semiconductor (ORG2) 22, can be used materials including, but not limited to: an organic dye molecule such as cyanine, porphyrin, or phthalocyanine or a derivative thereof; a triphenylamine derivative; a polyacene such as pentacene or a polyacene derivative; a carbazole derivative; a triphenyldiamine derivative; and a triazole derivative. These materials may be used as a single layer or a mixed layer of two materials or more.

The emission layer (EMI) 25 can be made of a material such as an aluminum-quinolinol complex or a carbazole derivative, or more preferably one of these materials to which a fluorescent material or a phosphorescent material both having a high emission efficiency is added.

A method for forming the organic EL device 10 will be described below. First, an ITO film is grown up to a thickness of about 100 nano-meters (nm) by sputtering to form the source electrode 11. Then, the first organic semiconductor layer 21 of copper phthalocyanine (CuPc), the gate electrode 13 of aluminum (Al), and the second organic semiconductor layer 22 of copper phthalocyanine (CuPc) are formed by a vapor deposition method under a high vacuum of approximately 1 x 10⁻⁵ pascals (Pa).

The first and second organic semiconductor layers 21 and 22 are grown so as to have a layer thickness of approximately 50nm. The gate electrode 13 is formed of aluminum deposited on the first organic semiconductor layer 21 so as to have a layer thickness of approximately 30nm. In this case, the aluminum does not cover the entire surface of the first organic semiconductor layer 21, but is deposited under a film forming condition that generates random voids 13A in the area of the gate electrode 13. Since the second organic semiconductor (copper phthalocyanine) is formed also in the voids by formation of the second organic semiconductor layer 22 on the gate electrode 13, the first organic semiconductor layer 21 contacts the second organic semiconductor layer 22 through the voids 13A or through-holes.

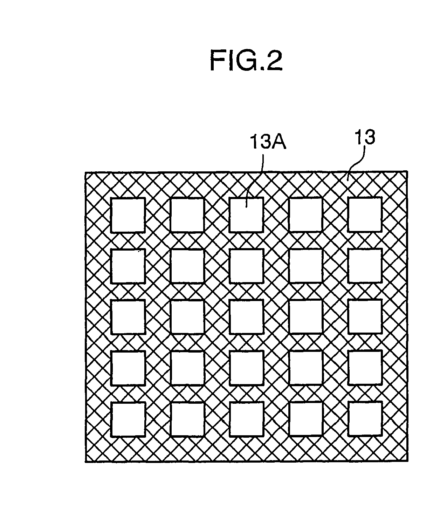

The gate electrode 13 may be formed in any shapes that can make a contact between the first and second organic semiconductor layers 21 and 22. For example, using a mask process, the gate electrode 13 may be formed in various shapes such as mesh-shape or stripe-shape. For example, when the gate electrode 13 is formed in a mesh shape, a part of its plan view in the plane perpendicular to a direction in which the layers are stacked (i.e., a part of a section taken along the line W in Fig. 1) is shown in Fig. 2. Alternatively, the gate electrode 13 may be formed in a comb shape.

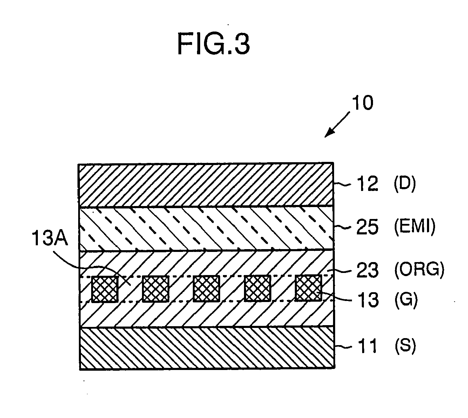

As shown in Fig. 3, the gate electrode 13 may also be formed so that it is buried in a single organic semiconductor layer (ORG) 23. In this case, it suffices for the gate electrode 13 to be formed inside the single organic semiconductor layer 23, so the gate electrode 13 may be formed anywhere.

On the second organic semiconductor layer 22, an aluminum-quinolinol complex (Alq3) is co-deposited with Nile red at a ratio of 100:5 to form the emission layer (EMI) 25.

On the emission layer (EMI) 25, magnesium is co-deposited with silver at a ratio of 100:5 to form the drain electrode 12.

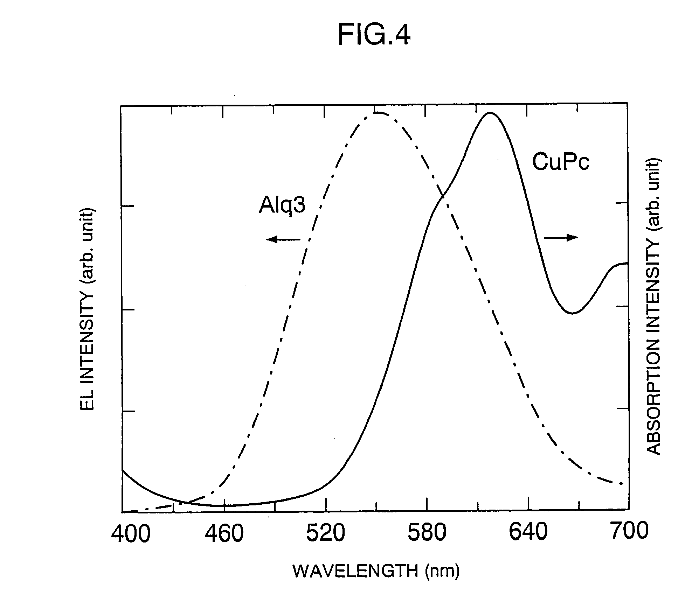

Fig. 4 shows an EL emission spectrum (dashed line) of the emission layer 25 and an absorption spectrum (solid line) of copper phthalocyanine (CuPc) used for the first and second organic semiconductor layers 21 and 22. As described above, Nile red of a fluorescent material is doped into an aluminum-quinolinol complex used for the emission layer 25. The actual emission spectrum of the emission layer 25 is thereby shifted to longer wavelengths than that of the aluminum-quinolinol complex (Alq3). Incidentally, an appropriate doping of a fluorescent material can increase the emission efficiency, but too much doping decreases the emission efficiency.

The first and second semiconductor layers 21 and 22 are thus formed so as to absorb a part of the wavelength band of the light emitted from the emission layer 25.

The operation of the above-described organic EL device 10 will now be described in detail with reference to the attached drawings.

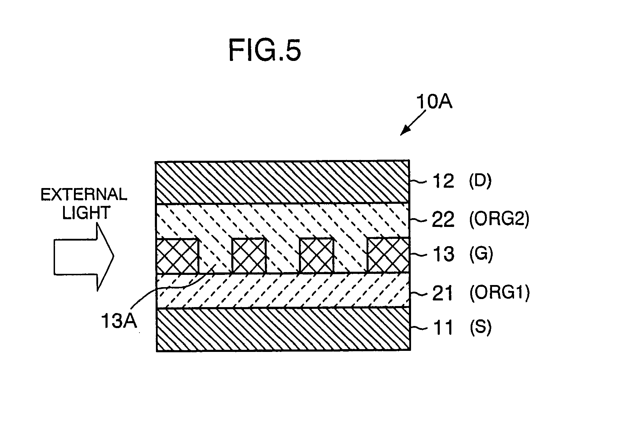

Fig. 5 is a cross-sectional view showing the configuration of a photosensitive static induction transistor (SIT) 10A, which is used for understanding the basic operation of the organic EL device 10. The configuration of the photosensitive SIT 10A is identical to that of the organic EL device 10 except that the emission layer 25 of the organic EL device 10 is not formed.

What a photosensitive SIT means here is that it has a gate electrode between a source electrode and a drain electrode and shows the same current-versus-voltage characteristics as a static induction transistor (SIT), but the controllability of its gate electrode changes by illumination with the light including a certain wavelength.

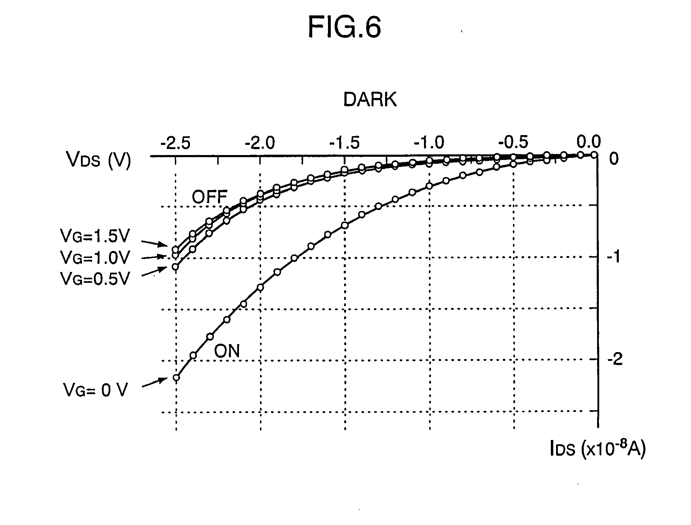

Fig. 6 shows characteristics of the drain-source current (I_{DS}) versus the drain-source voltage (V_{DS}) as a function of the gate voltage (V_{G}), i.e., source-gate voltage, for the photosensitive SIT 10A, obtained without external light illumination. The photosensitive SIT 10A was in a conductive (ON) state at a gate voltage (V_{G}) of 0V, but it was switched to a non-conductive (OFF) state by an applied voltage of 0.5V.

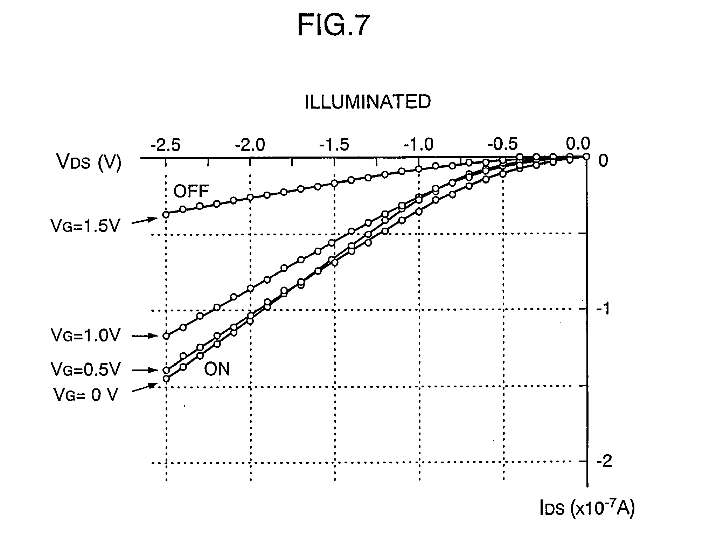

Fig. 7 shows characteristics of the drain-source current (I_{DS}) versus the drain-source voltage (V_{DS}) for the photosensitive SIT 10A, obtained with illumination by external light. The photosensitive SIT 10A was in a conductive (ON) state at a gate voltage (V_{G}) of 0V and kept the conductive (ON) state even when the gate voltage was increased up to 1V. When the gate voltage was further increased up to 1.5V, then the state was changed to a non-conductive (OFF) state.

As shown in Figs. 6 and 7, it is confirmed that the switching characteristics of the photosensitive SIT 10A as a function of the gate voltage varies with or without illumination by external light.

Next, the operation of the organic EL device 10 shown in Fig. 1 will be described. When a DC voltage of 10V was applied between the source electrode 11 and the drain electrode 12 with no voltage applied between the source electrode 11 and the gate electrode 13 (V_{G} = 0V), it was confirmed that the organic EL device 10 emitted light with a luminous intensity of approximately 78 candelas. After that, even when a voltage of 0.5V was applied between the source electrode 11 and the gate electrode 13, the emission was still maintained. Next, when a voltage of 1.5V was applied between the source electrode 11 and the gate electrode 13, the emission was turned off. After that, even when a voltage of 0.5V was applied between the source electrode 11 and the gate electrode 13, the emission remained off. Next, when a voltage between the source electrode 11 and the gate electrode 13 was backed to 0V, it was confirmed that the organic EL device 10 emitted light again with a luminous intensity of about 78 candelas.

The above-described operation of the organic EL device 10 can be understood as follows. When the light emitted from the emission layer 25 is not absorbed by the first and second organic semiconductor layers 21 and 22, applying a voltage to the gate electrode 13 causes the gate potential to increase, the current flowing through the emission layer 25 to decrease, and thus the luminous intensity to decrease. According to the present invention, however, the light emitted from the emission layer 25 is absorbed by the first and second organic semiconductor layers 21 and 22, thereby holes are generated and the gate potential is decreased by the generated holes. Due to this mechanism, the light emitted from the emission layer 25 can be maintained because current supply to the emission layer 25 is not decreased even at an applied voltage which has conventionally caused the current supply to decrease if the light emitted from the emission layer 25 is not absorbed by the first and second organic semiconductor layers 21 and 22. When the applied voltage to the gate electrode 13 is further increased, however, the current supply is decreased, thereby reducing the luminous intensity down to a sufficiently small level in comparison with the one when the gate voltage is not applied, within a time less than micro-second (µsec) order from the application of the gate voltage.

In the present embodiment, the light emitted from the emission layer 25 has been described as being absorbed by the first and second organic semiconductor layers 21 and 22, but only one of the first organic layer 21 and the second organic semiconductor layer 22 may be constituted as a light-absorbing layer that can absorb the emitted light. In this case, it is preferable to choose the first organic semiconductor layer 21 as the light-absorbing layer. In the above descriptions, the emission efficiency of the emission layer and/or the emission spectrum shift have been described as being adjusted by adding a dopant to the emission layer, but a dopant may also be added to the light-absorbing layer. That is, the light absorption coefficient of the light-absorbing layer may be adjusted by adding a dopant to the emission layer and/or adding a dopant to the light-absorbing layer to obtain a predetermined value or a value within a predetermined range.

### [Second Embodiment]

An organic EL device 10 of an optical thyristor type according to a second embodiment of the present invention will now be described.

The layer configuration of this embodiment is identical to that of the first embodiment, but the first and second organic semiconductor layers 21 and 22 are formed by depositing merocyanine (MC). The gate electrode (G) 13 is formed of magnesium. An aluminum-quinolinol complex (Alq3) is co-deposited with coumarin-6 at a ratio of 100:3 to form the emission layer 25. Further, the drain electrode 12 is formed by co-depositing aluminum and lithium.

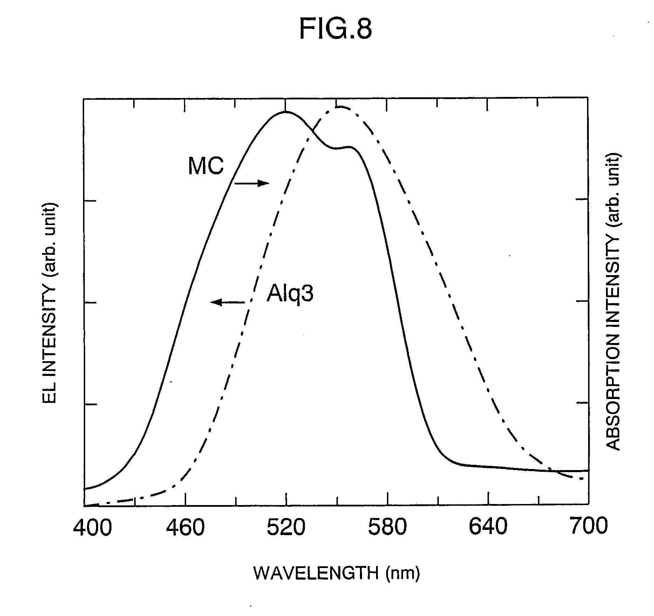

Fig. 8 shows an EL emission spectrum (dashed line) of the emission layer 25 and an absorption spectrum (solid line) of merocyanine (MC) used for the first and second organic semiconductor layers 21 and 22. As described above, coumarin-6 is doped in an aluminum-quinolinol complex used for the emission layer 25, whereby the emission efficiency of the emission layer 25 is increased while the emission spectrum shift is small.

It was confirmed in the operation of the present embodiment, as in the first embodiment, that the emission could be controlled according to an applied voltage to the gate electrode 13.

### [Third Embodiment]

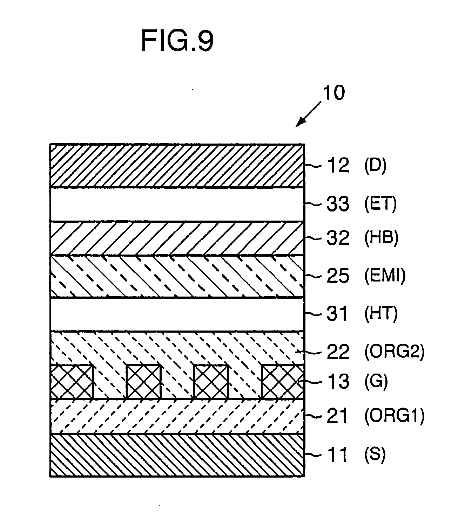

Fig. 9 is a cross-sectional view schematically showing the configuration of an organic EL device 10 of an optical thyristor type according to a third embodiment of the present invention.

The third embodiment differs from the first embodiment in that there is provided a hole transport layer (HT) 31 between the second organic semiconductor layer 22 and the emission layer 25, a hole blocking layer (HB) 32 on the emission layer 25, and an electron transport layer (ET) 33 on the hole blocking layer 32.

The first and second organic semiconductor layers 21 and 22 are p-type organic semiconductor layers. Therefore, this organic EL device 10 serves not only as a light-emitting device but also as a p-type SIT that can be controlled according to an applied voltage to the gate electrode 13.

The second organic semiconductor layer 22, the hole transport layer 31, the hole blocking layer 32, and the electron transport layer 33 may be provided as necessary. Alternatively, a hole injection layer may be provided between the source electrode 11 and first organic semiconductor layer 21.

In the organic EL device 10 according to the embodiment, it was confirmed that the emission could be controlled according to an applied gate voltage (V_{G}) while a voltage of 10V was applied between the source electrode (anode) 11 and the drain electrode (cathode) 12.

### Fourth Embodiment

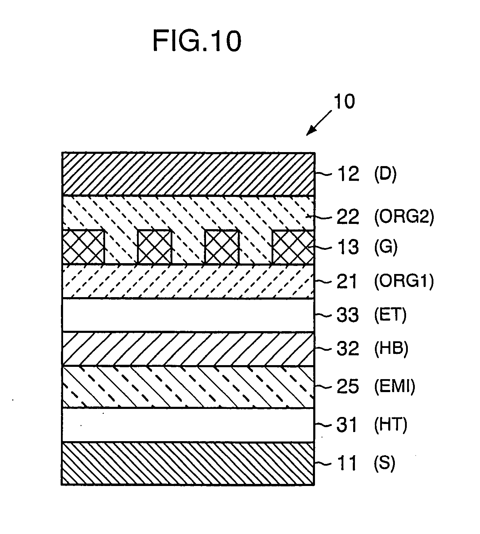

Fig. 10 is a cross-sectional view schematically showing the configuration of an organic EL device 10 of an optical thyristor type according to a fourth embodiment of the invention.

The fourth embodiment differs from the third embodiment in that the organic EL device 10 is configured so as to operate not only as a light-emitting device but also as an n-type SIT that be controlled according to an applied voltage to a gate electrode 13.

More specifically, a hole transport layer 31, an emission layer 25, a hole blocking layer 32, an electron transport layer 33, a first organic semiconductor layer 21, the gate electrode 13, a second organic semiconductor layer 22, and a drain electrode 12 are stacked on a source electrode 11 in this order from bottom up to form the organic EL device 10. Here, the first and second organic semiconductor layers 21 and 22 are n-type organic semiconductor layers. The organic EL device 10 serves not only as a light-emitting device but also as an n-type SIT that can be controlled according to an applied voltage to the gate electrode 13.

As described in detail above, the present invention provides an active organic EL device having thyristor characteristics. Accordingly, for example, using the organic EL device according to the present invention in a display apparatus can simplify its electronic circuit for each pixel. A low cost active drive display having a low power consumption and a high luminance can thereby be achieved. As a result, a long life, high reliability, high performance display can be obtained.

The invention has been described above with reference to the preferable embodiments. Those skilled in the art will understand that further variations and modifications are possible within the scope of the invention, which is defined in the appended claims.

## Claims

1. An organic semiconductor light-emitting device being an organic EL device having a first electrode, a second electrode, and an emission layer provided between the first and second electrodes, comprising:
an organic semiconductor layer provided between the first electrode and the emission layer, having an absorption band within an emission wavelength band of the emission layer; and
a control electrode electrically coupled to the organic semiconductor layer.

2. The organic semiconductor light-emitting device according to claim 1, wherein the organic semiconductor layer includes a light absorption layer having the absorption band, and the control electrode contacts the light absorption layer.

3. The organic semiconductor light-emitting device according to claim 1, wherein the organic semiconductor layer includes a light absorption layer having the absorption band, and the control electrode is buried in the light absorption layer.

4. The organic semiconductor light-emitting device according to claim 2, wherein the light absorption layer is formed between the control electrode and the first electrode.

5. The organic semiconductor light-emitting device according to claim 1, wherein at least one of the emission layer and the organic semiconductor layer is doped with a dopant so that a light absorption coefficient of the organic semiconductor layer is within a predetermined range.

6. The organic semiconductor light-emitting device according to claim 1, wherein current versus voltage characteristics between the first and second electrodes as a function of an applied voltage to the control electrode has thyristor characteristics in which the current versus voltage characteristics varies depending on whether the emission layer emits or not.

7. The organic semiconductor light-emitting device according to claim 1, further comprising a hole transport layer provided between the first electrode and the emission layer wherein the first electrode and the second electrode are an anode and a cathode, respectively.

8. The organic semiconductor light-emitting device according to claim 1, further comprising an electron transport layer provided between the second electrode and the emission layer wherein the first electrode and the second electrode are an anode and a cathode, respectively.
